# DEMANDE DE BREVET EUROPEEN

(11) **EP 0 643 490 A1**
(43) Date de publication de la demande: **15.03.1995**
(21) Numéro de dépôt: 94401990.0
(22) Date de dépôt: 07.09.1994
(51) Int. Cl.: H03M 7/30

(54) **Procédé de compression et de décompression d'un flux de valeurs numériques héxadécimales codées**

(30) Priorité: 09.09.1993 FR 9310731
(71) Demandeur: ALCATEL MOBILE COMMUNICATION FRANCE, 75008 Paris (FR)
(72) Inventeur: Helard, Yannick, F-53000 Laval (FR); Huon, Jean-Robert, F-95800 Courdimanche (FR)
(74) Mandataire: El Manouni, Josiane

(57) **Abrégé**

Procédé de compression d'un flux incident de valeurs numériques hexadécimales {0, 1, 2 ... 9, A, B, ... F} se présentant sous forme d'une suite d'octets source contenant chacun la valeur numérique codée {'0', '1', '2', ... '9', 'A', 'B', ... 'F'} obtenue suivant un code susceptible de coder un ensemble de caractères, chacun des caractères codés obtenus suivant ce code étant formé de bits de poids fort communs à certains caractères et de bits de poids faible propres à ce caractère, et lesdites valeurs numériques héxadécimales codées n'ayant pas toutes les mêmes bits de poids fort, caractérisé par les étapes consistant à :
(a) pour chaque octet source (O1,O2, ... Oi, ... On), transposer certaines desdites valeurs numériques codées en caractères codés autres, de façon à obtenir de mêmes bits de poids fort,
(b) extraire les quatre bits de poids le plus faible (Oib3, Oib2, Oib1, Oib0) de chacun des octets obtenus à l'étape (a) pour donner un quartet (I) représentant de façon univoque la valeur numérique hexadécimale initiale correspondante ; et
(c) concaténer les quartets successifs obtenus à l'étape (c) pour donner des octets codés résultants (O'1, O'2, ... O'i, ... O'm), en nombre (m) inférieur à celui (n) des octets source.

## Description

L'invention concerne un procédé de compression et de décompression de valeurs numériques.

Ce procédé est particulièrement adapté à la transmission de données entre un calculateur et un mobile par une liaison radiotéléphonique série du type de celles que l'on rencontre dans les systèmes de radiotéléphonie mobile privés (dits "PMR").

Cette application, si elle est avantageuse, n'est cependant pas limitative et le procédé de l'invention pourrait s'appliquer à divers autres types de transmission de données numériques.

Dans la présente description, le terme "données numériques" sera entendu au sens strict, c'est-à-dire correspondant à la représentation d'un nombre, à l'exclusion de la transmission de données alphanumériques non numériques telles que lettres, signes de ponctuation, caractères de commande, etc.

Plus précisément, l'invention s'applique à la transmission de valeurs numériques hexadécimales (base 16), se présentant sous la forme d'une succession de valeurs appartenant à l'ensemble {0, 1, 2 ... 9, A, B, ... F}.

Plus précisément encore, l'invention s'applique au cas particulier où ces valeurs numériques hexadécimales se présentent sous forme d'une suite d'octets contenant chacun le code ASCII, noté '0', '1', '2', ... '9', 'A', 'B', ... 'F', de la valeur numérique correspondante.

Cette forme de codage est notamment employée, dans le domaine précité de la radiotéléphonie mobile, pour le téléchargement de mémoires reprogrammables, par exemple du type "flash EPROM", d'un radiotéléphone mobile. Ici encore, cette application n'est pas limitative et l'invention peut s'appliquer à d'autres types de données à transmettre.

Par ailleurs la présente invention n'est pas limitée au cas de code ASCII mais pourrait également s'appliquer à tout code susceptible de coder un ensemble de caractères, chacun des caractères codés obtenus suivant ce code étant formé de bits de poids fort communs à certains caractères et de bits de poids faible propres à ce caractère.

Du fait que l'on utilise pour la transmission des données une liaison radio, il est important de pouvoir minimiser le temps de transmission, c'est-à-dire le temps d'occupation du canal radio utilisé.

L'invention a précisément pour objet de réduire, au moyen d'un algorithme de compression/décompression particulier, le nombre d'octets à transmettre sur la liaison série et, par voie de conséquence, la durée de cette transmission. On verra plus loin que la réduction ainsi obtenue est supérieure à 40 %, en conservant bien entendu l'intégrité totale des données transmises.

A cet effet, le procédé de compression de l'invention, qui opère sur un flux incident de valeurs numériques hexadécimales {0, 1, 2, ...9, A, B, ...F} se présentant sous forme d'une suite d'octets source contenant chacun la valeur numérique codée correspondante {'0', '1', '2' ... '9', 'A', 'B', ... 'F'} obtenue suivant un code susceptible de coder un ensemble de caractères incluant les dites valeurs numériques, chacun des caractères codés obtenus suivant ce code étant formé de bits de poids fort communs à certains caractères et de bits de poids faible propres à ce caractère, et lesdites valeurs numériques héxadécimales codées n'ayant pas toutes les mêmes bits de poids fort, ce procédé est caractérisé par les étapes consistant à :
(a) pour chaque octet source (01, 02, ... Oi, ... On), transposer certaines desdites valeurs numériques codées en caractères codés autres, de façon à obtenir de mêmes bits de poids fort,
(b) extraire les quatre bits de poids le plus faible (Oib3, Oib2, Oib1, Oib0) de chacun des octets obtenus à l'étape (a) pour donner un quartet (I) représentant de façon univoque la valeur numérique hexadécimale initiale correspondante; et
(c) concaténer les quartets successifs obtenus à l'étape (c) pour donner des octets codés résultants (O'1, O'2, ... O'i, ... O'm), en nombre (m) inférieur à celui (n) des octets source.

De préférence, à l'étape (c), on concatène les quartets successifs par groupes de sept bits successifs et on insère entre chacun de ces groupes un bit séparateur de valeur fixe prédéfinie.

L'invention concerne également le procédé de décompression associé, qui est caractérisé par les étapes consistant à :
(d) discriminer du flux de données incident les quartets successifs représentant la valeur numérique hexadécimale recherchée correspondante,
(e) associer à chaque quartet ainsi discriminé quatre bits de poids plus fort, correspondant auxdits mêmes bits de poids fort, de manière à obtenir un octet contenant un caractère codé suivant ledit code, et
(f) pour chaque octet de code obtenu à l'étape (e), faire la transposition inverse de celle définie à l'étape (a), de manière à obtenir un flux résultant de catactères {'0', '1', '2'... '9', 'A', 'B', ... 'F'} représentatifs des valeurs numériques hexadécimales recherchées.

D'autres caractéristiques et avantages de l'invention apparaîtront à la lecture de la description détaillée ci-dessous, faite, à titre d'exemple, plus particulièrement dans le cas du code ASCII, en référence aux dessins annexés.

La figure 1 est un tableau donnant, conformément au code ASCII, la représentation binaire des données numériques à traiter par la procédé de l'invention.

La figure 2 montre un ensemble de six octets de données, correspondant à six chiffres hexadécimaux, avant mise en oeuvre du procédé de compression de l'invention.

La figure 3 montre les données de la figure 2 sous forme comprimée, après mise en oeuvre du procédé de l'invention.

Comme on l'a indiqué plus haut, le but de l'invention est de réaliser une fonction de compression/décompression qui transforme une suite d'octets représentative de nombres hexadécimaux, plus exactement représentés par une suite de chiffres codés en ASCII, en une autre suite d'octets qui ne contienne que les bits utiles avec insertion de bits de synchronisation, par exemple un bit à zéro tous les sept bits.

Chaque octet de la suite de valeurs hexadécimales est donc codé par des caractères ASCII. Ainsi, la valeur hexadécimale "78" sera codée par les deux caractères consécutifs '7' et '8', la valeur "2F" par les deux caractères '2' et 'F', etc.

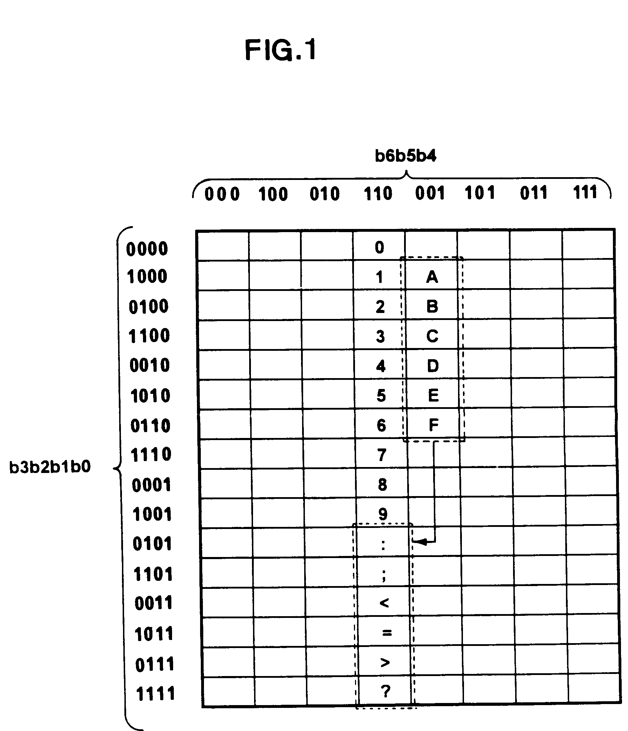

En ce qui concerne les valeurs concernées par la présente invention, à savoir les caractères '0', '1', '2' ... '9', 'A', 'B', ... 'F', leur codage dans la table de concordance ASCII est donné figure 1 : on voit que la représentation ASCII des chiffres 0 à 9 sera donnée par les valeurs binaires 1100000 à 1101001, tandis que les lettres A à F seront représentées par les valeurs binaires 0011000 à 0010110 (sur le tableau de la figure 1, chaque ligne donne la valeur binaire des quatre bits de poids le plus faible b3, b2, b1 et b0, tandis que chaque colonne donne la valeur binaire des bits de poids plus fort b6, b5 et b4 ; le bit de parité est le bit de poids le plus fort b7.

Comme on le voit, pour discriminer les différentes valeurs concernées, il faudra analyser les sept bits b6 à b0, soit sept bits significatifs pour coder seize valeurs différentes.

La première étape du traitement de compression de l'invention va consister à transposer les caractères 'A' à 'F' pour donner respectivement les caractères ':', ';', '<', '=', '>' et'?', de sorte que les bits b6, b5 et b4 seront toujours les mêmes et que l'on ne se trouvera plus en présence que de quatre bits significatifs, à savoir les bits b3, b2, b1 et b0, pour coder les seize valeurs différentes, les bits b6, b5 et b4 étant alors toujours respectivement 1,1 et 0 quelle que soit la valeur numérique hexadécimale concernée.

Une fois cette transposition effectuée, on va pouvoir procéder à la compression proprement dite des données.

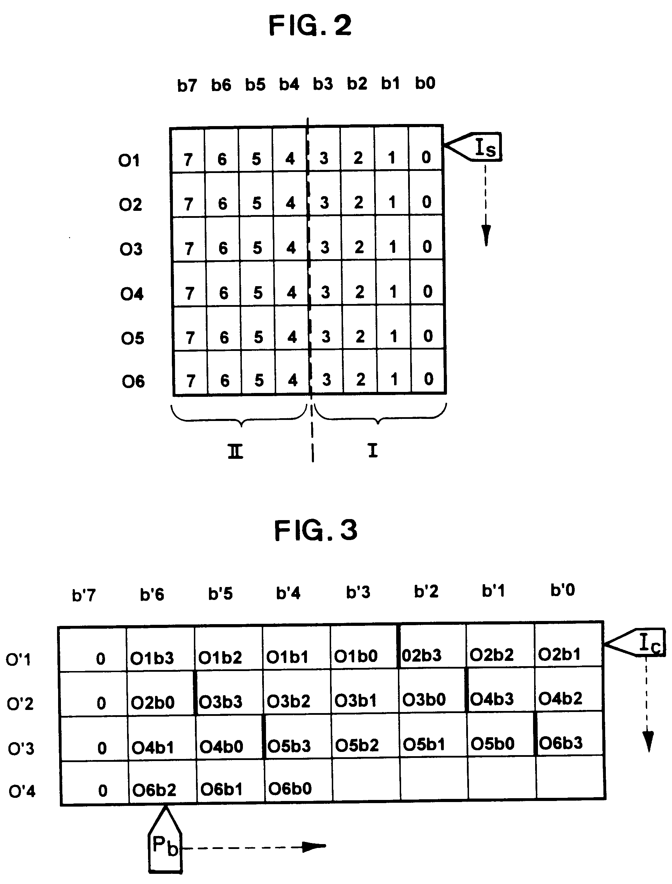

Celles-ci se présentent, avant compression, sous la forme illustrée figure 2, à savoir une succession d'octets O1, O2, ... Oi, ... O6,... codant chacun un caractère ASCII de la suite de nombres à transmettre.

Comme on vient de l'exposer, la transposition de ('A', 'B','C', 'D', 'E' et 'F'} en {':', ';', '<', '=', '>' et'?'} permet de limiter les valeurs significatives au quartet de poids le plus faible I constitué des bits b3, b2, b1 et b0, le quartet de poids le plus fort II étant constitué de bits non significatifs (bit b7 de parité et bits b6, b5 et b4 ayant une valeur constante 1, 1 et 0).

La compression va consister à ne conserver que le quartet de poids le plus faible (quartet I) de chaque octet O1, O2,... et concaténer ces quartets successifs pour donner des octets codés résultants, en nombre inférieur à celui des octets source.

La figure 3 donne la configuration de ces octets codés résultants O'1, O'2, ... O'j,...; sur cette figure, la notation "Oxby" signifie "bit y de l'octet Ox de la suite d'octets illustrée figure 2" (après la transposition préalable exposée plus haut).

On choisit de placer un caractère de synchronisation à chaque octet résultant, par exemple en mettant à zéro le bit de poids le plus fort b'7 de chaque octet O'j. Il ne s'agit là cependant que d'un détail de conception non essentiel, et d'autres configurations peuvent être envisagées (un bit de synchronisation tous les deux octets, synchronisation par le dernier bit de chaque octet au lieu du premier, etc.), l'exemple donné du premier bit de chaque octet mis à zéro n'étant que purement illustratif.

Comme on peut le voir, la compression a permis de réduire le volume de données, pour six octets O1, ... O6 de départ, à trois octets et demi O'1, ... O'4. De façon générale, si l'on prévoit d'insérer un bit de synchronisation à chaque octet, le taux de compression sera de 12:7, soit 1,7 environ, ce qui correspond à une réduction du volume des données à transmettre de l'ordre de 42 %.

En d'autres termes, on peut considérer que l'on a acrru la proportion de bits utiles du flux de données, qui passe de 50 % de bits utiles (4 bits sur 8) pour les données originelles O1, O2 ... à 87,5 % de bits utiles (7 bits sur 8) pour les données sous forme comprimée O'1, O'2, ...

On va maintenant donner un exemple détaillé d'algorithme de traitement permettant d'effectuer cette compression de données.

Cet algorithme de compression proprement dit devra être précédé, comme on l'a expliqué, d'une étape de transposition des caractères ASCII 'A', 'B','C', 'D', 'E' et 'F' en ':', ';', '<', '=', '>' et'?', respectivement (cf. tableau de la figure 1). Cette transposition, ne pose aucune difficulté particulière de programmation et peut être réalisée soit par l'intermédiaire d'une table de correspondance, les différents caractères ASCII étant alors considérés globalement, soit par analyse et modification éventuelle des différents bits de chaque caractère.

L'algorithme de compression proprement dit va traiter un tampon de n octets (que l'on suppose donc préalablement transposés) contenant : un caractère de début, (n-2) octets de données (du type O1, O2, ... de la figure 2) et un caractère de fin, et donne en sortie un tampon de m octets contenant : un caractère de début, (m-2) octets de données (du type O'1, O'2, ... de la figure 3) et un caractère de fin.

Cet algorithme général de compression sera présenté en méta-langage.

La valeur POSITION BIT (Pb sur la figure 3) est un pointeur indiquant le numéro du prochain bit à écrire dans le tampon de sortie. Sa valeur est initialisée à 6, car on écrira de gauche à droite les différents bits de chaque octet résultant (du bit b'6 au bit b'0), le bit b'7 étant toujours à zéro.

La valeur INDEX SOURCE (Is sur la figure 2) est un pointeur indiquant le numéro de l'octet en cours d'extraction dans le tampon d'entrée. Sa valeur est initialisée à 1 (octet O1 sur la figure 2), la valeur 0 représentant le caractère de début, non significatif, du tampon d'entrée.

La valeur INDEX CIBLE (Ic sur la figure 3) est un pointeur indiquant le numéro de l'octet en cours d'écriture dans le tampon de sortie. Sa valeur est initialisée à 1 (octet O'1 de figure 3), la valeur 0 représentant le caractère de début, non significatif, du tampon de sortie.

L'algorithme de compression des données est le suivant.
Tant que octet lu <> caractère de fin
TRAITEMENT
Écriture caractères début et fin du tampon de sortie
Fin tant que

Proc TRAITEMENT
Si (POSITION BIT)=6 alors TR6
Si (POSITION BIT)=5 alors TR5
Si (POSITION BIT)=4 alors TR4
Si (POSITION BIT)=3 alors TR3
Si (POSITION BIT)=2 alors TR2
Si (POSITION BIT)=1 alors TR1
si (POSITION BIT)=0 alors-TR0

Proc TR6
Si dernier caractère de l'octet source
Incrémentation INDEX CIBLE
Sinon
Extraction bits b3 à b0 de l'octet pointé par INDEX SOURCE
Incrémentation INDEX SOURCE
Écriture dans bits b'6 à b'3 de l'octet pointé par INDEX CIBLE
2 → POSITION BIT

Proc TR5
Si dernier caractère de l'octet source
0 → bits b'5 à b'0 de l'octet pointé par INDEX CIBLE
Incrémentation INDEX CIBLE
Sinon
Extraction bits b3 à b0 de l'octet pointé par INDEX SOURCE
Incrémentation INDEX SOURCE
Écriture dans bits b'5 à b'2 de l'octet pointé par INDEX CIBLE
1 → POSITION BIT

Proc TR4
Si dernier caractère de l'octet source
0→4 bits b'4 à b'0 de l'octet pointé par INDEX CIBLE
Incrémentation INDEX CIBLE
Sinon
Extraction bits b3 à b0 de l'octet pointé par INDEX SOURCE
Incrémentation INDEX SOURCE
Écriture dans bits b'4 à b'1 de l'octet pointé par INDEX CIBLE
0 → POSITION BIT

Proc TR3
Si dernier caractère de l'octet source
0 → bits b'3 à b'0 de l'octet pointé par INDEX CIBLE
Incrémentation INDEX CIBLE
Sinon
Extraction bits b3 à b0 de l'octet pointé par INDEX SOURCE
Incrémentation INDEX SOURCE
Écriture dans bits b'3 à b'0 de l'octet pointé par INDEX CIBLE
6 → POSITION BIT

Proc TR2
Si dernier caractère de l'octet source
0 → bits b'2 à b'0 de l'octet pointé par INDEX CIBLE
Incrémentation INDEX CIBLE
Sinon
Extraction bits b3 à b1 de l'octet pointé par INDEX SOURCE
Écriture dans bits b'2 à b'0 de l'octet pointé par INDEX CIBLE
Incrémentation INDEX CIBLE
Extraction bit b0 de l'octet pointé par INDEX SOURCE
Écriture dans bit b'6 de l'octet pointé par INDEX CIBLE
Incrémentation INDEX SOURCE
5 → POSITION BIT

Proc TR1
Si dernier caractère de l'octet source
0 → bits b'1 et b'0 de l'octet pointé par INDEX CIBLE
Incrémentation INDEX CIBLE
Sinon
Extraction bits b3 et b2 de l'octet pointé par INDEX SOURCE
Écriture dans bits b'1 et b'0 de l'octet pointé par INDEX CIBLE
Incrémentation INDEX CIBLE
Extraction bits b1 et b0 de l'octet pointé par INDEX SOURCE
Écriture dans bits b'6 et b'5 de l'octet pointé par INDEX CIBLE
Incrémentation INDEX SOURCE
4 → POSITION BIT

Proc TR0
Si dernier caractère de l'octet source
0 → bit b'0 de l'octet pointé par INDEX CIBLE
Incrémentation INDEX CIBLE
Sinon
Extraction bit b3 de l'octet pointé par INDEX SOURCE
Écriture dans bit b'0 de l'octet pointé par INDEX CIBLE
Incrémentation INDEX CIBLE
Extraction bits b2 à b0 de l'octet pointé par INDEX SOURCE
Écriture dans bits b'6 à b'4 de l'octet pointé par INDEX CIBLE
Incrémentation INDEX SOURCE
3 → POSITION BIT

On va maintenant décrire l'algorithme de décompression des données, qui opère de manière inverse, *mutatis mutandis*, de celui de l'algorithme de compression.

Cet algorithme de décompression proprement dit devra être suivi, comme on l'a expliqué, d'une étape de transposition inverse des caractères, afin de retrouver le codage ASCII normalisé (cf. tableau de la figure 1). Cette transposition inverse, tout comme la transposition directe, ne pose aucune difficulté particulière de programmation et ne sera pas décrite en détail.

La structure des données de départ est celle de la figure 3, à savoir une série d'octets contenant des caractères comprimés. La structure d'arrivée est celle de la figure 2, à savoir un tampon de m octets contenant des caractères décomprimés.

La valeur POSITION BIT est un pointeur indiquant le numéro du prochain bit à écrire dans le tampon de sortie. Sa valeur est initialisée à 7, car on écrira de gauche à droite, du bit b7 au bit b0.

La valeur INDEX CIBLE est un pointeur indiquant le numéro de l'octet en cours d'écriture dans le tampon de sortie. L'initialisation de cette valeur dépend de l'endroit où l'on veut écrire les données reçues, et correspond par exemple à l'adresse de début d'une zone de mémoire RAM ou flash EPROM, etc.
Tant que octet lu <> caractère de fin
TRAITEMENT
Écriture caractères début et fin du tampon de sortie
Fin tant que
Proc TRAITEMENT

Si (POSITION BIT)=7 alors TR7
si (POSITION BIT)=6 alors TR6
Si (POSITION BIT)=5 alors TR5
Si (POSITION BIT)=4 alors TR4
Si (POSITION BIT)=3 alors TR3
Si (POSITION BIT)=2 alors TR2
Si (POSITION BIT)=1 alors TR1
Si (POSITION BIT)=0 alors TR0

Proc TR7
Décalage de 1 position vers la gauche de l'octet reçu
Écriture dans position du tampon pointée par INDEX CIBLE
0 → POSITION BIT

Proc TR6
Extraction bit B7 de l'octet pointé par INDEX CIBLE
Écriture dans position du tampon pointée par INDEX CIBLE
du bit B7
et de l'octet reçu
Incrément INDEX CIBLE
7 → POSITION BIT

Proc TR5
Extraction bits B7 et B6 de l'octet pointé par INDEX CIBLE
Écriture dans position du tampon pointée par INDEX CIBLE
des bits B7 et B6
et de l'octet reçu, décalé de 1 position vers la droite
Incrément INDEX CIBLE
Décalage de 7 positions vers la gauche de l'octet reçu
Écriture dans position du tampon pointée par INDEX CIBLE
6 → POSITION BIT

Proc TR4
Extraction bits B7 à B5 de l'octet pointé par INDEX CIBLE
Écriture dans position du tampon pointée par INDEX CIBLE
des bits B7 à B5
et de l'octet reçu, décalé de 2 positions vers la droite
Incrément INDEX CIBLE
Décalage de 6 positions vers la gauche de l'octet reçu
Écriture dans position du tampon pointée par INDEX CIBLE
5 → POSITION BIT

Proc TR3
Extraction bits B7 à B4 de l'octet pointé par INDEX CIBLE
Écriture dans position du tampon pointée par INDEX CIBLE
des bits B7 à B4
et de l'octet reçu, décalé de 3 positions vers la droite Incrément INDEX CIBLE
Décalage de 5 positions vers la gauche de l'octet reçu
Écriture dans position du tampon pointée par INDEX CIBLE
4 → POSITION BIT

Proc TR2
Extraction bits B7 à B3 de l'octet pointé par INDEX CIBLE
Écriture dans position du tampon pointée par INDEX CIBLE
des bits B7 à B3 et de l'octet reçu, décalé de 4 positions vers la droite
Incrément INDEX CIBLE
Décalage de 4 positions vers la gauche de l'octet reçu
Écriture dans position du tampon pointée par INDEX CIBLE
3 → POSITION BIT

Proc TR1
Extraction bits B7 à B2 de l'octet pointé par INDEX CIBLE
Écriture dans position du tampon pointée par INDEX CIBLE
des bits B7 à B2
et de l'octet reçu, décalé de 5 positions vers la droite
Incrément INDEX CIBLE
Décalage de 3 positions vers la gauche de l'octet reçu
Écriture dans position du tampon pointée par INDEX CIBLE
2 → POSITION BIT

Proc TR0
Extraction bits B7 à B1 de l'octet pointé par INDEX CIBLE
Écriture dans position du tampon pointée par INDEX CIBLE
des bits B7 à B1
et de l'octet reçu, décalé de 6 positions vers la droite
Incrément INDEX CIBLE
Décalage de 2 positions vers la gauche de l'octet reçu
Écriture dans position du tampon pointée par INDEX CIBLE
1 → POSITION BIT

## Revendications

1. Procédé de compression d'un flux incident de valeurs numériques hexadécimales {0, 1, 2 ... 9, A, B, ... F} se présentant sous forme d'une suite d'octets source contenant chacun la valeur numérique codée {'0','1','2', ... '9', 'A', 'B', ... 'F'} obtenue suivant un code susceptible de coder un ensemble de caractères, chacun des caractères codés obtenus suivant ce code étant formé de bits de poids fort communs à certains caractères et de bits de poids faible propres à ce caractère, et lesdites valeurs numériques héxadécimales codées n'ayant pas toutes les mêmes bits de poids fort, caractérisé par les étapes consistant à :
(a) pour chaque octet source (O1,O2, ... Oi, ... On), transposer certaines desdites valeurs numériques codées en caractères codés autres, de façon à obtenir de mêmes bits de poids fort,
(b) extraire les quatre bits de poids le plus faible (Oib3, Oib2, Oib1, Oib0) de chacun des octets obtenus à l'étape (a) pour donner un quartet (I) représentant de façon univoque la valeur numérique hexadécimale initiale correspondante ; et
(c) concaténer les quartets successifs obtenus à l'étape (c) pour donner des octets codés résultants (O'1, O'2, ... O'i, ... O'm), en nombre (m) inférieur à celui (n) des octets source.

2. Procédé selon la revendication 1, caractérisé en ce que à l'étape (c), on concatène les quartets successifs par groupes de sept bits successifs (b'6 ... b'0) et on insère entre chacun de ces groupes un bit séparateur (b'7) de valeur fixe prédéfinie.

3. Procédé de décompression d'un flux de valeurs numériques hexadécimales codées par mise en oeuvre du procédé selon la revendication 1, caractérisé par les étapes consistant à :
(d) discriminer du flux de données incident les quartets successifs représentant la valeur numérique hexadécimale recherchée correspondante,
(e) associer à chaque quartet ainsi discriminé quatre bits de poids plus fort, correspondant auxdits mêmes bits de poids fort, de manière à obtenir un octet contenant un caractère codé suivant ledit code, et
(f) pour chaque octet de code obtenu à l'étape (e), faire la transposition inverse de celle définie à l'étape (a) de manière à obtenir un flux résultant de caractères {'0', '1', '2', ... '9', 'A', 'B', ... 'F'} représentatif des valeurs numériques hexadécimales {0, 1, 2 ..., 9, A, B ... F} recherchées

4. Procédé selon l'une des revendications 1 à 3, caractérisé en ce que ledit code consiste dans le code ASCII et en ce que ladite étape (a) consite pour chaque octet source (O1, O2, ... Oi, ... On), à transposer les caractères ASCII {'A','B','C','D','E', et 'F'} respectivement en {':', ';', '<', '=', '>' et '?'} et à laisser inchangés les caractères '0'à '9'.
